# EUROPEAN PATENT SPECIFICATION

(11) **EP 3 962 047 B1**
(45) Date of publication and mention of the grant of the patent: **17.06.2026**
(21) Application number: 21169648.9
(22) Date of filing: 21.04.2021
(51) Int. Cl.: H04M 1/02, C09J 5/00

(54) **ELECTRONIC DEVICE**
ELEKTRONISCHE VORRICHTUNG
DISPOSITIF ÉLECTRONIQUE

(30) Priority: 31.08.2020 CN 202010899619
(43) Date of publication of application: 02.03.2022
(73) Proprietor: Beijing Xiaomi Mobile Software Co., Ltd., Beijing 100085 (CN)
(72) Inventor: CHANG, Cheng, Beijing, Beijing 100085 (CN)
(74) Representative: Gunzelmann, Rainer

(56) References cited:
- WO-A1-2019/124810
- DE-A1- 10 245 564
- DE-A1- 102004 050 949
- GB-A- 2 527 135
- US-A1- 2013 092 326
- US-A1- 2016 062 391
- US-A1- 2020 389 984

## Description

### TECHNICAL FIELD

The present application relates to the technical field of a terminal, and in particular to an electronic device.

### BACKGROUND

For the components which cannot be fastened by a locking member such as a screw in an electronic device, glue is usually used for adhering and fixing the components. Besides, in order to ensure the adhering strength between the components, glue with higher adhesion is usually used for adhering.

However, in the assembling process of the electronic device, there will inevitably be a situation in which disassembly is required for reassembling due to assembly errors or misoperations. Or in the maintenance process, disassembly of the components is also required. If the adhesion of the glue for adhering to the components is too strong, the difficulty for disassembly is increased, and the increase of the disassembling force in the disassembling process may even cause damage to the components, resulting in a decrease in yield.

DE102004050949A1 discloses a process for recycling electrical and/or electronic components, the process having a method step in which a bond between two components of the component brought about by means of a pressure-sensitive adhesive is broken by expandable particles present in the pressure-sensitive adhesive expanding through the supply of energy.

US20160062391A1 discloses an electronic device having a curved surface display area. The electronic device includes a display and a housing supporting the display. The display includes glass including an edge having a certain curvature, an opaque layer disposed at the edge of the glass, and a panel module layer including a non-display area disposed under the opaque layer.

DE10245564A1 discloses that two half-shells are glued together by a thermoplastic adhesive foil with an embedded electrical heater wire. The wire has end terminals situated close together in a tag which is visible in the battery pocket in one of the shells. The other shell has apertures to accommodate pushbuttons and a small video screen.

GB2527135A discloses an adhesive that allows articles such as components of an electrical device, to be bonded and de-bonded comprising a thermoplastic adhesive capable of bonding articles and a ferromagnetic material that is in thermal contact with the thermoplastic, where by the ferromagnetic material is heated by induction heating which melts the thermoplastic allowing the adhesive to bond or to de-bonded as required.

US20130092326A1 discloses a method for separating bonded bodies that includes a step that irradiates excimer light with a central wavelength of 1 to 300 nm on to a bonded body that has been formed by using an adhesive composition to bond substrates together, which includes and is formed by one type or two or more types of meth (acrylate) that have one or more (meth)acryloyl groups, and by hardening of said adhesive composition. At least one of the substrates is permeable to the excimer light.

WO2019/124810A1 discloses an electronic device, which includes: a housing including a first surface, a second surface facing the direction opposite to the first surface, and a side surface encompassing a space between the first surface and the second surface; a front plate arranged on the first surface of the housing; a display arranged between the front plate and the first surface such that at least part thereof is exposed through the front plate; at least one functional member arranged between the display and the first surface; and an adhesive member arranged between the functional member and the first surface so as to attach the function member to the housing. The adhesive member includes an adhesive part for attaching the functional member to the first surface, and at least one non-adhesive part extending from the adhesive part.

### SUMMARY

The present invention is defined by independent claim 1. Further aspects of the present invention are defined by the dependent claims. The present application provides an electronic device, to address deficiencies in the related art.

According to the present invention, an electronic device is provided. The electronic device includes:
a first member;
a second member;
an adhesive layer adhered between the first member and the second member, an adhesion of the adhesive layer is decreased by adjusting environmental conditions.

The electronic device further includes a third member and a fourth member, and a preset adhesive layer is provided between the third member and the fourth member.

An adhesion of the preset adhesive layer is independent of a lighting parameter, a magnetic field parameter, an electric field parameter, and a vibration parameter.

In some embodiments, the adhesive layer includes an optical type adhesive layer. An adhesion of the optical type adhesive layer is decreased by adjusting a light intensity within a predetermined wavelength.

In some embodiments, the optical type adhesive layer includes an ultraviolet light (UV) type adhesive layer.

In some embodiments, the UV type adhesive layer includes an intermediate film layer, a first glue layer and a second glue layer. The intermediate film layer is provided between the first glue layer and the second glue layer. The first glue layer is a UV glue layer, and the second glue layer is different from the UV glue layer.

In some embodiments, the first member includes a display screen of the electronic device, and the second member includes a housing of the electronic device.

In some embodiments, the adhesive layer is provided between at least a portion of a first surface of the display screen and the housing. The first surface is a surface of the display screen in a thickness direction of the display screen.

In some embodiments, the adhesive layer is provided between at least a portion of a second surface of the display screen and the housing. The second surface is a surface of the display screen opposite to a display side and facing toward interior of the electronic device.

In some embodiments, the display screen further includes a circuit board. A signal transmission line of the display screen extends out of the display screen from a same side edge of the display screen and is electrically connected to the circuit board.

The adhesive layer is provided on other side edges of the display screen different from said same side edge.

In some embodiments, the display screen includes a planar display area and at least one curved display area. Each curved display area is connected to an edge of the planar display area and curved with respect to the planar display area. The adhesive layer is provided between the curved display area and the housing.

The technical solution provided by the embodiments of the present application includes the following beneficial effects.

As known from the above embodiments, in the present application, the adhesion of the adhesion-reducing adhesive layer can be decreased by subjecting the adhesion-reducing adhesive layer to predefined environmental conditions, so that when the first member and the second member are disassembled, the difficulty for disassembling the first member and the second member can be decreased by decreasing the adhesion of the adhesion-reducing adhesive layer, thereby reducing the risk of damage to the first member or the second member due to disassembly therebetween.

Understandably, the above general description and the following detailed description are merely exemplary and explanatory, and are not intended to limit the present application.

### BRIEF DESCRIPTION OF THE DRAWINGS

The accompanying drawings here, which are incorporated into the description and constitute a part of the description, illustrate embodiments that conform to the present application and are used together with the description to explain the principles of the application.
FIG. 1 is a schematic diagram of an electronic device according to an exemplary embodiment of the present invention.
FIG. 2 is a partial schematic diagram of the electronic device of FIG. 1 of the
FIG. 3 is a cross-sectional schematic diagram of an adhesion-reducing adhesive layer according to an exemplary embodiment of the present invention.
FIG. 4 is a schematic diagram that shows a connection between a display screen and a housing according to an exemplary embodiment of the present invention.
FIG. 5 is a schematic diagram that shows a connection between a display screen and an adhesion-reducing adhesive layer according to an exemplary embodiment of the present invention.
FIG. 6 is a schematic diagram of a display screen according to an exemplary embodiment of the present invention.

### DETAILED DESCRIPTION

Exemplary embodiments will be described here in detail, and examples thereof are represented in the accompanying drawings. When the following description relates to the accompanying drawings, unless otherwise indicated, the same reference numeral in different accompanying drawings represents the same or similar elements. The implementations described in the following exemplary embodiments do not represent all implementations consistent with the present application. On the contrary, they are merely examples of apparatuses consistent with some aspects of the present application as detailed in the appended claims.

In the following description, although numerous features may be designated as optional, it is nevertheless acknowledged that all features defined by claim 1 are not to be read as optional.

Terms used in the present application are merely for describing specific embodiments and are not intended to limit the present application. The singular forms "one", "the", and "this" used in the present application and the appended claims are also intended to include a multiple form, unless other meanings are clearly represented in the context. It should also be understood that the term "and/or" used in the present application refers to any or all of possible combinations including one or more associated listed items.

It should be understood that although terms "first", "second", "third", and the like are used in the present application to describe various information, the information is not limited to the terms. These terms are merely used to differentiate information of a same type. For example, without departing from the scope of the present application, first information is also referred to as second information, and similarly, the second information is also referred to as the first information. Depending on the context, for example, the term "if" used herein may be explained as "when" or "while", or "in response to ..., it is determined that".

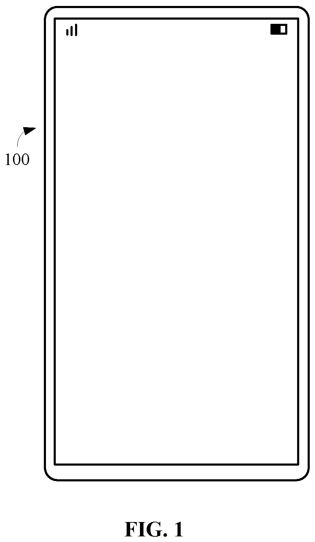

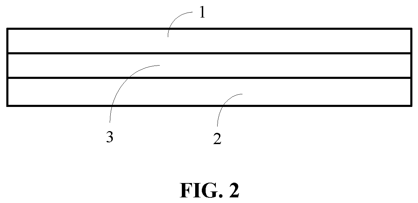

FIG. 1 is a schematic diagram of an electronic device 100 according to an exemplary embodiment of the present invention, and FIG. 2 is a partial schematic diagram of the electronic device 100 of FIG. 1. As shown in FIG. 1 and FIG. 2, the electronic device 100 may include a mobile phone terminal. Certainly, in other embodiments, the electronic device 100 may further include various terminal devices, such as a tablet terminal, a computer terminal, a wearable device, an intelligent home device, etc. In the interior of the electronic device 100, in order to realize the connection and fixing between the components arranged adjacent to each other, it is generally necessary to provide a locking member. Moreover, when the components cannot be perforated, it is necessary to use an adhesive tape or the like to realize the connection.

Therefore, as shown in FIG. 2, the electronic device 100 includes a first member 1 to be adhered, a second member 2 to be adhered, and an adhesion-reducing adhesive layer 3 adhered between the first member 1 and the second member 2. The adhesion of the adhesion-reducing adhesive layer 3 is associated with the environmental conditions. The environmental conditions include lighting conditions. When the light intensity is strong enough, the adhesion of the adhesion-reducing adhesive layer 3 is decreased. While under a normal ambient light condition, the adhesion of the adhesion-reducing adhesive layer 3 is relatively strong, so that the first member 1 and the second member 2 can be firmly adhered. Certainly, in addition to the lighting conditions, the environmental conditions also include magnetic field conditions, electric field conditions, or vibration conditions of the environment in which the electronic device 100 is located. The environmental conditions are multiple conditions among the following conditions: lighting conditions, magnetic field conditions, electric field conditions, or vibration conditions, which is not limited in the present application.

Therefore, in the present application, the adhesion of the adhesion-reducing adhesive layer 3 can be reduced by subjecting the adhesion-reducing adhesive layer to predefined environmental conditions, so that when the first member 1 and the second member 2 are disassembled, the adhesion of the adhesion-reducing adhesive layer 3 is decreased by adjusting the environmental conditions. Therefore, the difficulty for disassembling the first member 1 and the second member 2 can be decreased, while reducing the risk of damage to the first member 1 or the second member 2 due to disassembly therebetween.

In some embodiments of the present invention, the adhesion-reducing adhesive layer 3 may include an optical type adhesion-reducing adhesive layer. The adhesion of the optical type adhesion-reducing adhesive layer is associated with the light intensity within a predetermined wavelength. When the light intensity is strong enough, the adhesion of the optical type adhesion-reducing adhesive layer is decreased, to facilitate disassembling the first member 1 and the second member 2. Moreover, the reduction of the adhesion of the optical type adhesion-reducing adhesive layer under the natural lighting condition can be avoided by setting the wavelength of the light, so that a problem of weak adhesion can be avoided. Herein, the optical type adhesion-reducing adhesive layer may include an ultraviolet light (UV) type adhesion-reducing adhesive layer. The adhesion of the UV type adhesion-reducing adhesive layer is weakened under irradiation of a LED lamp with the wavelength between 365 nm and 385 nm.

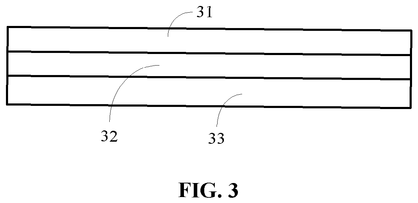

As shown in FIG. 3, the optical type adhesion-reducing adhesive layer may include a first glue layer 31, an intermediate film layer 32 and a second glue layer 33. The intermediate film layer 32 is provided between the first glue layer 31 and the second glue layer 33 for connecting the first glue layer 31 and the second glue layer 33 with each other. The first glue layer 31 may be a UV glue layer, and the second glue layer 33 is different from the UV glue layer. That is, the adhesion of the second glue layer 33 is independent of the irradiation of UV light. The intermediate film layer may include a Polyethylene terephthalate (PET) film layer. When the UV type adhesion-reducing adhesive layer has not been adhered to the first member 1 and the second member 2, the UV type adhesion-reducing adhesive layer may further include a release film. The first glue layer 31 and the second glue layer 33 are protected against dust through the release film, so that the adhesion of the first glue layer 31 and the second glue layer 33 is prevented from being decreased.

The electronic device 100 further includes a third member to be adhered and a fourth member to be adhered. A preset adhesive layer is provided between the third member and the fourth member. The adhesion of the preset adhesive layer is independent of the environmental conditions, which can prevent weakening the adhesion of the preset adhesive layer while weakening the adhesion of the adhesion-reducing adhesive layer 3 by improving the environmental conditions, thereby preventing the insufficient adhering strength between the third member and the fourth member. Alternatively, the environmental conditions for reducing the adhesion of the adhesion-reducing adhesive layer 3 are different from the environmental conditions for reducing the adhesion of the preset adhesive layer, which can also prevent weakening the adhesion of the preset adhesive layer while weakening the adhesion of the adhesion-reducing adhesive layer 3 by improving the environmental conditions. Herein, each of the third member and the fourth member may be an internal stacked layer of the first member 1 or the second member 2. Alternatively, each of the third member and the fourth member may be another component other than the first member 1 and the second member 2, which is not limited in the present application.

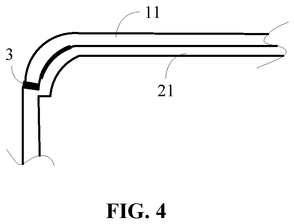

In the above embodiment of the present invention, as shown in FIG. 4, the first member 1 may include a display screen 11 of the electronic device 100, and the second member 2 may include a housing 21. The adhesion-reducing adhesive layer 3 may be adhered between the display screen 11 and the housing 21. In particular, when the display screen 11 is a flexible display screen, the adhesion of the UV type adhesion-reducing adhesive layer is decreased through the irradiation of the ultraviolet (UV) light, and then the flexible display screen and the housing 21 are disassembled, so that the damage to the flexible display screen in the disassembling process can be greatly reduced. As still shown in FIG. 3, the adhesion-reducing adhesive layer 3 can be adhered between a first surface of the display screen 11 and the housing 21. The first surface of the display screen 11 is a surface of the display screen 11 in a thickness direction of the display screen 11. The first surface of the display screen 11 is adhered to the housing 21 utilizing adhesion-reducing adhesive layer 3, so that the gap between the housing 21 and the display screen 11 of the electronic device 100 can be reduced, or there is even no gap formed between the display screen 11 and the housing 21, thereby improving the dustproof and waterproof property of the electronic device 100. Herein, the adhesion-reducing adhesive layer 3 may be adhered to a portion of the first surface or may be adhered to the entire first surface, which is not limited thereto.

In the embodiment of the present invention shown in FIG. 4, the adhesion-reducing adhesive layer 3 may also be provided between a second surface of the display screen 11 and the housing 21. The second surface of the display screen is a surface facing toward the interior of the electronic device 100 and provided opposite to a display side of the display screen 11. Since the area of the second surface is relatively large, the adhesive area of the adhesion-reducing adhesive layer 3 may be increased, thereby improving the adhesive strength. The adhesion-reducing adhesive layer 3 may be adhered to a portion of the second surface or attached to the entire second surface, which is not limited thereto. In other embodiments, the adhesion-reducing adhesive layer 3 may be provided only between the first surface and the housing 21, or only between the second surface and the housing 21, which may be specifically designed as desired and is not limited in the present application.

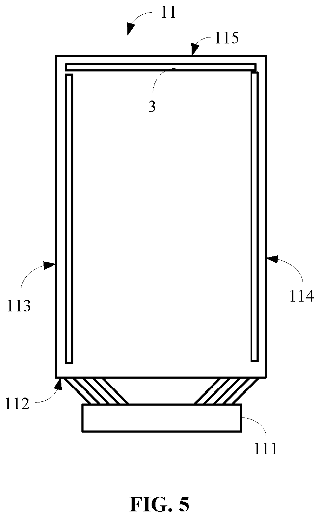

Further, the adhesion-reducing adhesive layer 3 may be adhered to an edge region of the display screen 11. In some embodiments of the present invention, as shown in FIG. 5, the display screen 11 may include a circuit board 111. A data line of the display screen 11 may extend out of an interior of the display screen from a same side edge of the display screen to be electrically connected to the circuit board 111. That is, in the embodiment of the present invention shown in FIG. 5, the data line may extend out of the display screen 11 from the first edge 112 of the display screen 11 to be electrically connected to the circuit board 111, and the adhesion-reducing adhesive layer 3 may be provided on other side edges of the display screen 11 which are different from the first edge 112. In some embodiments of the present invention, as shown in FIG. 4, the adhesion-reducing adhesive layer 3 may be provided on a second edge 113, a third edge 114 and a fourth edge 115 of the display screen 11, so that the region from which the data line extends out of the display screen 11 may be successively bypassed, thereby avoiding the connection between the adhesion-reducing adhesive layer 3 and the data lines, and avoiding tearing and damage of the data lines. Certainly, in other embodiments, the adhesion-reducing adhesive layer 3 may be provided on one side edge or two side edges of the second edge 113, the third edge 114 and the fourth edge 115, which is not limited in the present application. The adhesion-reducing adhesive layer 3 at either side edge may be provided in at least one position of a position between the surface adjacent to the display side of the display screen 11 and the housing 21, and a position between the surface opposite to the display side of the display screen 11 and the housing 21.

In the above embodiments not being part of the present invention, the strength and the endurance of the display screen 11, as well as the bearing capacity of the internal structure of the display screen 11 to the external force are all relatively weak with respect to the housing 21. Therefore, in order to prevent the adhesion-reducing adhesive layer 3 from driving the internal structure of the display screen 11 into slide when the display screen 11 and the housing 21 are disassembled, the first glue layer 31 may be connected to the display screen 11, and the second glue layer 33 may be connected to the housing 21. In this way, the adhesive strength between the first glue layer 31 and the display screen 11 may be weakened by the irradiation of the UV light, which facilitates reducing the force acting on the display screen 11 and avoiding damage to the display screen 11 due to the disassembly.

Further, understandably, the display screen 11 may include a plurality of stacked layers arranged in sequence in the thickness direction of the display screen 11. The third member may be a stacked layer, and the fourth member may be another stacked layer adjacent to the third member. The two stacked layers adjacent to each other may be adhered by a preset adhesive layer. The adhesion of the preset adhesive layer is independent of the environmental conditions that affect the adhesion of the adhesion-reducing adhesive layer 3. Therefore, when the display screen 11 and the housing 21 are disassembled, the adhesion of the preset adhesive layer can be prevented from being affected by the environmental conditions, which is possible to prevent the force for disassembling the display screen 11 and the housing 21 from acting on the display screen 11 and causing the interior sliding of the display screen 11, thereby preventing the adjacent stacked layers from being misaligned, affecting the display effect and damaging the display screen 11. Herein, the plurality of stacked layers may include one or more of the following layers: a display layer, a protective layer, a graphite layer, a copper foil layer and a flexible film layer.

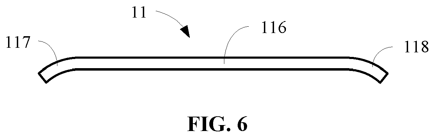

The display screen 11 may include a planar display screen. Alternatively, as shown in FIG. 6, the display screen 11 may include a planar display area 116, a first curved display area 117 and a second curved display area 118. The first curved display area 117 is connected to one side edge of the planar display area 116, and the second curved display area 118 is connected to another side edge of the planar display area 116 opposite to said one side edge. The first curved display area 117 and the second curved display area 118 may be configured for displaying, thereby promoting the display effect and the visual effect. Herein, the adhesion-reducing adhesive layer 3 may be provided in at least one of the first curved display area 117 and the second curved display area 118. For the curved display area, the thickness direction thereof is the same as the radial direction thereof. Therefore, the adhesion-reducing adhesive layer 3 may be provided between a surface of the first curved display area 117 or the second curved display area 118 provided along the radial direction and the housing 21. Alternatively, the adhesion-reducing adhesive layer 3 may also be provided on a surface on the first curved display area 117 or the second curved display area 118 facing toward the interior of the electronic device 100.

Understandably, the present application is not limited to the precise structure that has been described above and shown in the drawings, and that various modifications and changes can be made without departing from the scope thereof. The scope of the present application is limited only by the appended claims.

## Claims

1. An electronic device (100), comprising:
a first member (1);
a second member (2);
an adhesive layer (3) adhered between the first member (1) and the second member (2), wherein an adhesion of the adhesive layer (3) is decreased by adjusting environmental conditions,
wherein the electronic device (100) further comprises a third member and a fourth member, wherein a preset adhesive layer is provided between the third member and the fourth member,
**characterized in that**
an adhesion of the preset adhesive layer is independent of a lighting parameter, a magnetic field parameter, an electric field parameter, and a vibration parameter.

2. The electronic device (100) of claim 1, wherein the adhesive layer (3) comprises an optical type adhesive layer, and an adhesion of the optical type adhesive layer is decreased by adjusting a light intensity within a predetermined wavelength.

3. The electronic device (100) of claim 2, wherein the optical type adhesive layer comprises an ultraviolet light, UV, type adhesive layer.

4. The electronic device (100) of claim 3, wherein the UV type adhesive layer comprises an intermediate film layer (32), a first glue layer (31) and a second glue layer (33), and wherein the intermediate film layer (32) is provided between the first glue layer (31) and the second glue layer (33), the first glue layer (31) is a UV glue layer, and the second glue layer (33) is different from the UV glue layer.

5. The electronic device (100) of any one of claims 1 to 4, wherein the first member (1) comprises a display screen (11) of the electronic device (100), and the second member (2) comprises a housing (21) of the electronic device (100).

6. The electronic device (100) of claim 5, wherein the adhesive layer (3) is provided between at least a portion of a first surface of the display screen (11) and the housing (21), and wherein the first surface is a surface of the display screen (11) in a thickness direction of the display screen (11).

7. The electronic device (100) of claim 5, wherein the adhesive layer (3) is provided between at least a portion of a second surface of the display screen (11) and the housing (21), and wherein the second surface is a surface of the display screen (11) opposite to a display side and facing toward interior of the electronic device (100).

8. The electronic device (100) of any one of claims 5 to 7, wherein the display screen (11) further comprises a circuit board (111), a signal transmission line of the display screen (11) extends out of the display screen (11) from a same side edge of the display screen (11) and is electrically connected to the circuit board (111); and
wherein the adhesive layer (3) is provided on other side edges of the display screen (11) different from said same side edge.

9. The electronic device (100) of any one of claims 5 to 8, wherein the display screen (11) comprises a planar display area (116) and at least one curved display area (117, 118), each curved display area (117, 118) being connected to an edge of the planar display area (116) and curved with respect to the planar display area (116), and wherein the adhesive layer (3) is provided between the curved display area (117, 118) and the housing (21).

## Patentansprüche

1. Eine elektronische Vorrichtung (100), umfassend:
ein erstes Element (1);
ein zweites Element (2);
eine Klebeschicht (3), die zwischen dem ersten Element (1) und dem zweiten Element (2) haftet, wobei eine Haftung der Klebeschicht (3) durch Anpassen von Umgebungsbedingungen verringert wird,
wobei die elektronische Vorrichtung (100) ferner ein drittes Element und ein viertes Element umfasst, wobei eine vorgegebene Klebeschicht zwischen dem dritten Element und dem vierten Element bereitgestellt ist,
**dadurch gekennzeichnet, dass**
eine Haftung der vorgegebenen Klebeschicht von einem Beleuchtungsparameter, einem Magnetfeldparameter, einem elektrischen Feldparameter und einem Vibrationsparameter unabhängig ist.

2. Die elektronische Vorrichtung (100) nach Anspruch 1, wobei die Klebeschicht (3) eine Klebeschicht vom optischen Typ umfasst, und eine Haftung der Klebeschicht vom optischen Typ durch Anpassen einer Lichtintensität innerhalb einer vorbestimmten Wellenlänge verringert wird.

3. Die elektronische Vorrichtung (100) nach Anspruch 2, wobei die Klebeschicht vom optischen Typ eine Klebeschicht vom Ultraviolettlicht-, UV, Typ umfasst.

4. Die elektronische Vorrichtung (100) nach Anspruch 3, wobei die Klebeschicht vom UV-Typ eine Zwischenfilmschicht (32), eine erste Klebstoffschicht (31) und eine zweite Klebstoffschicht (33) umfasst, und wobei die Zwischenfilmschicht (32) zwischen der ersten Klebstoffschicht (31) und der zweiten Klebstoffschicht (33) bereitgestellt ist, die erste Klebstoffschicht (31) eine UV-Klebstoffschicht ist und die zweite Klebstoffschicht (33) von der UV-Klebstoffschicht verschieden ist.

5. Die elektronische Vorrichtung (100) nach einem der Ansprüche 1 bis 4, wobei das erste Element (1) einen Anzeigebildschirm (11) der elektronischen Vorrichtung (100) umfasst, und das zweite Element (2) ein Gehäuse (21) der elektronischen Vorrichtung (100) umfasst.

6. Die elektronische Vorrichtung (100) nach Anspruch 5, wobei die Klebeschicht (3) zwischen mindestens einem Abschnitt einer ersten Oberfläche des Anzeigebildschirms (11) und dem Gehäuse (21) bereitgestellt ist, und wobei die erste Oberfläche eine Oberfläche des Anzeigebildschirms (11) in einer Dickenrichtung des Anzeigebildschirms (11) ist.

7. Die elektronische Vorrichtung (100) nach Anspruch 5, wobei die Klebeschicht (3) zwischen mindestens einem Abschnitt einer zweiten Oberfläche des Anzeigebildschirms (11) und dem Gehäuse (21) bereitgestellt ist, und wobei die zweite Oberfläche eine Oberfläche des Anzeigebildschirms (11) ist, die einer Anzeigeseite gegenüberliegt und zu einem Inneren der elektronischen Vorrichtung (100) hin weist.

8. Die elektronische Vorrichtung (100) nach einem der Ansprüche 5 bis 7, wobei der Anzeigebildschirm (11) ferner eine Leiterplatte (111) umfasst, eine Signalübertragungsleitung des Anzeigebildschirms (11) sich von einer selben Seitenkante des Anzeigebildschirms (11) aus dem Anzeigebildschirm (11) heraus erstreckt und elektrisch mit der Leiterplatte (111) verbunden ist; und
wobei die Klebeschicht (3) an anderen Seitenkanten des Anzeigebildschirms (11) bereitgestellt ist, die von der genannten selben Seitenkante verschieden sind.

9. Die elektronische Vorrichtung (100) nach einem der Ansprüche 5 bis 8, wobei der Anzeigebildschirm (11) einen ebenen Anzeigebereich (116) und mindestens einen gekrümmten Anzeigebereich (117, 118) umfasst, wobei jeder gekrümmte Anzeigebereich (117, 118) mit einer Kante des ebenen Anzeigebereichs (116) verbunden und in Bezug auf den ebenen Anzeigebereich (116) gekrümmt ist, und wobei die Klebeschicht (3) zwischen dem gekrümmten Anzeigebereich (117, 118) und dem Gehäuse (21) bereitgestellt ist.

## Revendications

1. Un dispositif électronique (100), comprenant :
un premier élément (1) ;
un deuxième élément (2) ;
une couche adhésive (3) collée entre le premier élément (1) et le deuxième élément (2), dans lequel une adhérence de la couche adhésive (3) est diminuée en ajustant des conditions environnementales,
dans lequel le dispositif électronique (100) comprend en outre un troisième élément et un quatrième élément, dans lequel une couche adhésive prédéfinie est prévue entre le troisième élément et le quatrième élément,
**caractérisé en ce que**
une adhérence de la couche adhésive prédéfinie est indépendante d'un paramètre d'éclairage, d'un paramètre de champ magnétique, d'un paramètre de champ électrique et d'un paramètre de vibration.

2. Le dispositif électronique (100) selon la revendication 1, dans lequel la couche adhésive (3) comprend une couche adhésive de type optique, et une adhérence de la couche adhésive de type optique est diminuée en ajustant une intensité lumineuse dans une longueur d'onde prédéterminée.

3. Le dispositif électronique (100) selon la revendication 2, dans lequel la couche adhésive de type optique comprend une couche adhésive de type lumière ultraviolette, UV.

4. Le dispositif électronique (100) selon la revendication 3, dans lequel la couche adhésive de type UV comprend une couche de film intermédiaire (32), une première couche de colle (31) et une deuxième couche de colle (33), et dans lequel la couche de film intermédiaire (32) est prévue entre la première couche de colle (31) et la deuxième couche de colle (33), la première couche de colle (31) est une couche de colle UV, et la deuxième couche de colle (33) est différente de la couche de colle UV.

5. Le dispositif électronique (100) selon l'une quelconque des revendications 1 à 4, dans lequel le premier élément (1) comprend un écran d'affichage (11) du dispositif électronique (100), et le deuxième élément (2) comprend un boîtier (21) du dispositif électronique (100).

6. Le dispositif électronique (100) selon la revendication 5, dans lequel la couche adhésive (3) est prévue entre au moins une partie d'une première surface de l'écran d'affichage (11) et le boîtier (21), et dans lequel la première surface est une surface de l'écran d'affichage (11) dans une direction d'épaisseur de l'écran d'affichage (11).

7. Le dispositif électronique (100) selon la revendication 5, dans lequel la couche adhésive (3) est prévue entre au moins une partie d'une deuxième surface de l'écran d'affichage (11) et le boîtier (21), et dans lequel la deuxième surface est une surface de l'écran d'affichage (11) opposée à un côté d'affichage et orientée vers un intérieur du dispositif électronique (100).

8. Le dispositif électronique (100) selon l'une quelconque des revendications 5 à 7, dans lequel l'écran d'affichage (11) comprend en outre une carte de circuit imprimé (111), une ligne de transmission de signal de l'écran d'affichage (11) s'étend hors de l'écran d'affichage (11) depuis un même bord latéral de l'écran d'affichage (11) et est connectée électriquement à la carte de circuit imprimé (111) ; et
dans lequel la couche adhésive (3) est prévue sur d'autres bords latéraux de l'écran d'affichage (11) différents dudit même bord latéral.

9. Le dispositif électronique (100) selon l'une quelconque des revendications 5 à 8, dans lequel l'écran d'affichage (11) comprend une zone d'affichage plane (116) et au moins une zone d'affichage incurvée (117, 118), chaque zone d'affichage incurvée (117, 118) étant connectée à un bord de la zone d'affichage plane (116) et incurvée par rapport à la zone d'affichage plane (116), et dans lequel la couche adhésive (3) est prévue entre la zone d'affichage incurvée (117, 118) et le boîtier (21).
